# EUROPEAN PATENT APPLICATION

(11) **EP 2 837 866 A1**
(43) Date of publication of application: **18.02.2015**
(21) Application number: 13776263.9
(22) Date of filing: 15.03.2013
(51) Int. Cl.: F16K 31/70, B01J 19/00, B81B 1/00, B81C 3/00

(54) **VALVE, MICROFLUIDIC DEVICE, MICROSTRUCTURE, VALVE SEAT, METHOD FOR MANUFACTURING VALVE SEAT, AND METHOD FOR MANUFACTURING MICROFLUIDIC DEVICE**

(30) Priority: 12.04.2012 JP 2012091089
(71) Applicant: The University of Tokyo, Bunkyo-ku, Tokyo 113-8654 (JP); Nikon Corporation, Tokyo 100-8331 (JP)
(72) Inventor: ICHIKI Takanori, Tokyo 113-8654 (JP); TAKEHARA Hiroaki, Tokyo 113-8654 (JP); SHIONO Hirofumi, Tokyo 100-8331 (JP)
(74) Representative: Hoffmann Eitle
(86) International application number: PCT/JP2013/057453
(87) International publication number: WO 2013/153912

(57) **Abstract**

Provided is a valve formed of a shape-memory polymer disposed in a flow channel, in which a flow of fluid in the flow channel is adjusted by deformation of the valve.

## Description

### TECHNICAL FIELD

The present invention relates to a valve, a microfluidic device, a microstructure, a valve sheet, a method of manufacturing a valve sheet, and a method of manufacturing a microfluidic device.

### BACKGROUND

In recent years, development of µ-TAS (micro-total analysis systems) aimed at improvements in speed and efficiency for experiments and integration for experiments, or microminiaturization of examination instruments has been attracting attention in an extracorporeal diagnosis field, and active studies have proceeded globally.

µ-TAS is excellent in that it is possible to perform measurement and analysis using a small amount of specimen, it is portable, it is disposable at a low cost, and the like, compared to the examination instruments in the related art.

Furthermore, µ-TAS has been attracting attention as a highly efficient method in a case in which an expensive reagent is used or a small amount of multi-specimens is examined.

In µ-TAS, a microvalve is an essential element for controlling the flow of fluid containing a biological sample or the like in a flow channel in a chip.

A general microvalve proposed in the related art uses a movable member such as an actuator. However, in recent years, microvalves in which a flow channel is blocked by applying a gas pressure on the top of the flow channel has been proposed (refer to Patent Document 1 and Non-Patent Document 1).

### [Related Art Documents]

### [Patent Documents]

[Patent Document 1] Published Japanese Translation No. 2003-516129 of the PCT International Publication

### [Non-Patent Documents]

[Non-Patent Document 1] Marc A. Unger, et.al., Science, (2000) vol. 288, pp. 113-116.

### SUMMARY OF INVENTION

### PROBLEMS TO BE SOLVED BY THE INVENTION

However, in the microvalves disclosed in Patent Document 1 and Non-Patent Document 1, it is necessary to form a network of a gas flow channel on an upper portion of a flow channel through which fluid flows and there is room for improvement in view of simple manufacturing of the microvalves at a low cost.

In addition, use of such microvalves leaves little degree of freedom in designing the micro flow channel device.

Furthermore, it is necessary to send gas into a gas flow channel sequentially in order to block the flow channel and there is room for improvement in view of simple control of flow of fluid.

In view of foregoing, an object of the present invention is to provide a valve, which can be simply produced at a low cost and with which it is possible to simply and freely control the flow of fluid; a micro flow channel device and a microstructure which are provided with the valve; a valve sheet on which the valve is arranged; and a method of manufacturing the valve sheet and the micro flow channel device.

### MEANS FOR SOLVING THE PROBLEM

The present inventors have conducted extensive studies in order to solve the above-described problems and have found that it is possible to solve the above-described problems using a shape-memory polymer. Aspects of the present invention provide the following (1) to (9).
(1) A valve in an aspect of the present invention is a valve formed of a shape-memory polymer disposed in a flow channel, in which a flow of fluid in the flow channel is adjusted by deformation of the valve.
(2) A structure in an aspect of the present invention is a structure formed of a shape-memory polymer disposed in a flow channel through which biomolecules flow, in which the structure is configured to have a deformation amount adjusted by controlling a heating condition.
(3) A fluidic device in an aspect of the present invention is a fluidic device provided with a valve formed of a shape-memory polymer disposed in a flow channel. The valve is at least one selected from the group consisting of a normally open valve of which the state is deformed from an open state in which fluid flows through the flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.
(4) A fluidic device in an aspect of the present invention is a fluidic device provided with a valve formed of a shape-memory polymer disposed in a flow channel. The fluidic device includes a normally open valve which is disposed on a first surface and of which the state is deformed from an open state in which fluid flows through the flow channel to a closed state in which the flow of the fluid is blocked; and a normally closed valve which is disposed on a second surface facing the first surface and of which the state is deformed from the closed state in which the flow of the fluid in the flow channel is blocked to the open state in which the fluid flows through the flow channel. The normally open valve and the normally closed valve are disposed so as to face each other.
(5) A fluidic device in an aspect of the present invention is a fluidic device provided with a pump configured to have a plurality of valves formed of a shape-memory polymer disposed in flow channels. The plurality of valves are at least two selected from the group consisting of a normally open valve of which the state is deformed from an open state in which fluid flows through the flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.
(6) A valve sheet in an aspect of the present invention is a valve sheet on which a valve formed of a shape-memory polymer is disposed. The valve is at least one selected from the group consisting of a normally open valve of which the state is deformed from an open state in which fluid flows through a flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.
(7) A method of manufacturing a valve sheet in an aspect of the present invention includes: molding a normally closed valve on the sheet by forming a first recess portion on a sheet made of a shape-memory polymer through molding processing or machining at a temperature less than the melting point of the shape-memory polymer and making the first recess portion flat by applying an external force to the first recess portion at a temperature within a range of higher than or equal to a shape recovery temperature of the shape-memory polymer and less than the melting point of the shape-memory polymer; and/or molding a normally open valve on the sheet by providing a second recess portion by applying an external force on the sheet at a temperature within the range of higher than or equal to the shape recovery temperature of the shape-memory polymer and less than the melting point of the shape-memory polymer.
(8) A method of manufacturing a valve sheet in an aspect of the present invention includes: molding a normally closed valve on the sheet by forming a first penetration hole on a sheet formed of a shape-memory polymer through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point of the shape memory polymer; and/or molding a normally open valve on the sheet by providing a second penetration hole by applying an external force on the sheet at a temperature within the range of higher than or equal to the shape recovery temperature of the shape-memory polymer and less than the melting point of the shape-memory polymer.
(9) A method of manufacturing a fluidic device in an aspect of the present invention is a method of manufacturing a flow channel device formed of a valve sheet and a flow channel forming layer, including: (a) manufacturing the valve sheet through a method of manufacturing the valve sheet including at least a step selected from the group consisting of a step of forming a first recess portion on a sheet formed of a shape-memory polymer through molding processing or machining at a temperature less than the melting point of the shape-memory polymer, making the first recess portion flat by applying an external force to the first recess portion at a temperature within a range of higher than or equal to a shape recovery temperature of the shape-memory polymer and less than the melting point of the shape-memory polymer, and forming a first normally closed valve on the sheet, a step of providing a second recess portion by applying an external force on the sheet at a temperature within the range of higher than or equal to the shape recovery temperature of the shape-memory polymer and less than the melting point of the shape-memory polymer and forming a first normally open valve on the sheet, a step of forming a first penetration hole through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point of the shape-memory polymer, and forming a second normally closed valve on the sheet, and a step of providing a second penetration hole by applying an external force on the sheet at a temperature within the range of higher than or equal to the shape recovery temperature of the shape-memory polymer and less than the melting point of the shape-memory polymer and forming a second normally open valve on the sheet; and (b) laminating the valve sheet, which is manufactured in the step (a), and the flow channel forming layer.

### ADVANTAGE OF THE INVENTION

According to the present invention, it is possible to simply control the flow of fluid.

### BRIEF DESCRIPTION OF THE DRAWINGS

FIG. 1 is a schematic view for describing a shape-memory polymer.
FIG. 2 is a schematic cross-sectional view of a mode of a valve in one embodiment.
FIG. 3 is a schematic cross-sectional view of a mode of a valve in one embodiment.
FIG. 4 is a schematic cross-sectional view of a mode of a valve in one embodiment.
FIG. 5 is a schematic cross-sectional view of a mode of a valve in one embodiment.
FIG. 6 is a schematic cross-sectional view of a mode of a valve in one embodiment.
FIG. 7 is a schematic cross-sectional view of a mode of a microstructure in one embodiment.
FIG. 8 is a front view of a mode of a valve sheet in one embodiment.
FIG. 9 is a front view of a mode of a microfluidic device in one embodiment.
FIG. 10 is a schematic view of a mode of a method of manufacturing a valve sheet in one embodiment.
FIG. 11 is a schematic view of a mode of a method of manufacturing a valve sheet in one embodiment.
FIG. 12 is a schematic view of a mode of a method of manufacturing a valve sheet in one embodiment.
FIG. 13 is a schematic view of a mode of a method of manufacturing a valve sheet in one embodiment.
FIG. 14 is a front view of a mode of a microfluidic device in one embodiment.
FIG. 15 is a schematic cross-sectional view of a mode of a microfluidic device in one embodiment.
FIG. 16 is a front view of a mode of a microfluidic device in one embodiment.
FIG. 17 is a schematic cross-sectional view of a mode of a microfluidic device in one embodiment.
FIG. 18 is a schematic view showing a process of manufacturing a microfluidic device in Example 1.
FIG. 19 is a result of confirming an operation of a microfluidic device in Example 1.
FIG. 20 is a result of confirming an operation of a microfluidic device in Example 1.
FIG. 21 is a result of confirming an operation of a microfluidic device in Example 2.
FIG. 22 is a result of confirming an operation of a microfluidic device in Example 3.
FIG. 23 is a result of confirming an operation of a microfluidic device in Example 4.
FIG. 24 is a result of confirming an operation of a microfluidic device in Example 5.
FIG. 25 is a result of confirming an operation of a microfluidic device in Example 6.

### DESCRIPTION OF EMBODIMENTS

### «Valve»

A valve of the present invention is formed of a shape-memory polymer disposed in a flow channel (flow passage) and adjusts the flow of fluid in the flow channel by being deformed.

The shape-memory polymer is a polymer that returns to its original shape when heated to a temperature higher than or equal to a certain temperature even if it is deformed by an external force applied after molding processing. The shape-memory polymer is configured to have a reversible phase that shows a fluidity at a temperature higher than or equal to a certain temperature (hereinafter, referred to as a shape recovery temperature) and a stationary phase formed of a physical or chemical bonding region (cross-linking point) which does not cause deformation at the temperature at which the reversible phase is deformed.

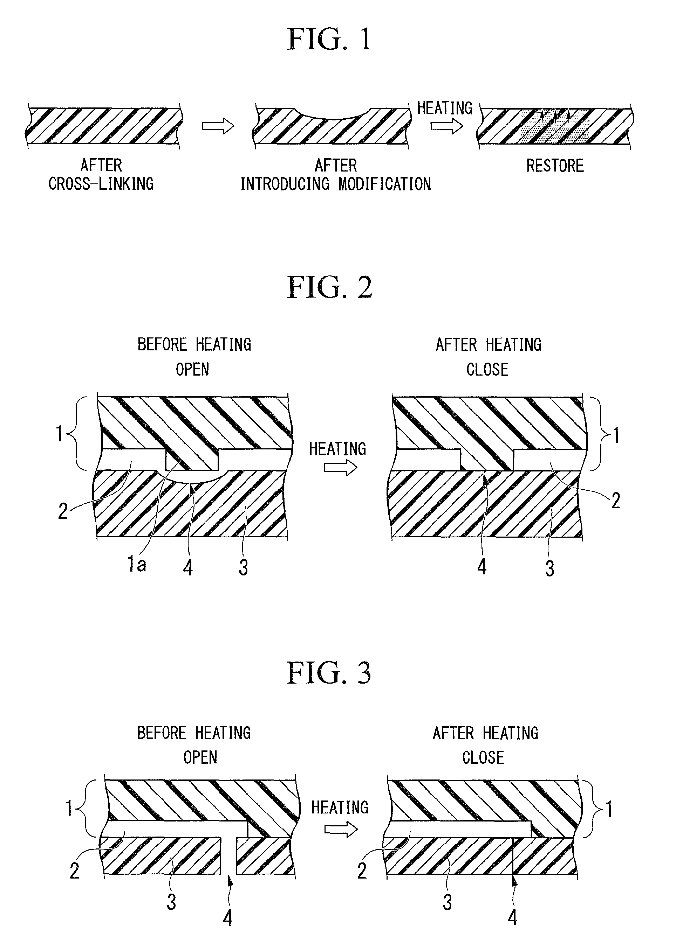

As shown in FIG. 1, the shape-memory polymer can retain the shape, which is formed through molding processing or machining, using the stationary phase in resin and can deform the retained shape in a free shape at a temperature within a range of higher than or equal to a shape recovery temperature and less than the melting point. Moreover, it is possible to fix the deformation by cooling the shape-memory polymer to a temperature less than the shape recovery temperature while maintaining the state being deformed. The fixed shape which is deformed by cooling the shape-memory polymer to a temperature less than the shape recovery temperature is restored to the shape which is formed through the molding processing or the machining by heating the shape-memory polymer to a temperature higher than or equal to the shape recovery temperature and less than the melting point.

In the present invention, a valve is molded from a shape-memory polymer through the molding processing or the machining. The valve is molded to be an open state in which fluid is made to flow through a flow channel or a closed state in which the flow of fluid is blocked.

Furthermore, after deforming the valve at a temperature within the range of higher than or equal to the shape recovery temperature of the shape-memory polymer and less than the melting point thereof, the deformation is fixed by cooling the valve to a temperature less than the shape recovery temperature. The deformation refers to a deformation in which the open state of the valve is made to be the closed state or a deformation in which the closed state of the valve is made to be the open state.

Thus, the deformed valve is disposed in a flow channel. When the shape of the deformed valve is the open state, fluid freely flows through the flow channel after the disposition of the valve. When the shape of the deformed valve is the closed state, the flow of fluid in the flow channel is blocked after the disposition of the valve.

Next, the shape of the valve is restored to the shape at the time of molding by heating the valve at the temperature within the range of higher than or equal to the shape recovery temperature of the shape-memory polymer and less than the melting point thereof. A valve which is deformed to be an open state enters a closed state by being heated and the flow of the fluid in the flow channel is blocked. A valve which is deformed to be a closed state enters an open state by being heated and the fluid freely flows through the flow channel.

In this manner, according to the present invention, it is possible to freely control the flow of the fluid in the flow channel by disposing the valve formed of the shape-memory polymer in the flow channel.

In addition, in the valve according to the present invention, at least a portion of the shape-memory polymer forms at least a portion of a flow channel, and therefore, it is possible to simply manufacture the valve at a low cost and to simply and freely control the open state and the closed state. In addition, the valve of the present invention can be deformed to the open state in which fluid is made to flow through a flow channel or to the closed state in which the flow of fluid is blocked by changing the temperature, for example, heating.

Hereinafter, preferred embodiments of the valve of the present invention will be described, but the embodiments will be described as an example for a better understanding of the scope of the invention and do not limit the present invention unless specified otherwise.

### <Microvalve>

The valves of the present embodiments are microvalves suitably used in a microfluidic device (fluidic device). Examples of the microvalves include a normally open valve, normally closed valve, and a series valve in which the normally open valve and the normally closed valve are disposed in series. The microfluidic device in the present embodiments may be a micrometer scale or a millimeter scale.

Hereinafter, each of the microvalves will be described in detail.

### [Normally Open Valve]

FIG. 2 is a schematic cross-sectional view showing a first embodiment of a valve of the present invention. The valve of the present embodiment is a normally open valve 4 which is deformed from an open state, in which fluid is made to flow through a flow channel 2, to a closed state, in which the flow of the fluid is blocked, by being heated.

### (Recess Shape)

As shown in FIG. 2, the flow channel 2 is formed by laminating a flow channel forming layer 1 and a sheet 3.

In FIG. 2, the flow channel 2 is formed by the flow channel forming layer 1 laminated on the sheet 3. However, the flow channel may be formed by a sheet laminated on a flow channel forming layer regardless of the hierarchical relationship.

The flow channel forming layer 1 has a barrier 1a and the flow of fluid in the flow channel 2 is blocked by the barrier 1a. On the contrary, the normally open valve 4 functions as a flow channel (bypass passage) as a bypass for making the fluid blocked by the barrier 1a bypass the barrier in a steady state.

The sheet 3 formed of the shape-memory polymer retains the flat shape at the time of molding. In FIG. 2, the normally open valve 4 is molded in a recess shape by applying an external force at a temperature within a range of higher than or equal to a shape recovery temperature of the shape-memory polymer and less than the melting point thereof.

Before heating, the normally open valve 4 is in an open state in which the fluid flows through the flow channel 2 and which has a shape for bypassing the closed state in which the flow of the fluid is blocked. Here, in FIG. 2, the open state of the normally open valve 4 is a state having a recess shape for bypassing the closed state. That is, the normally open valve 4 is in the open state having a recess shape in a steady state.

Moreover, the sheet 3 is restored to the flat shape after the heating, thereby being deformed to the closed state in which the flow of the fluid is blocked.

### (Penetration Shape)

In addition, as shown in FIG. 3, the open state of the normally open valve 4 may be a state having a penetration shape for bypassing the closed state. In FIG. 3, the normally open valve 4 is molded in a penetration shape by applying an external force at a temperature within a range of higher than or equal to a shape recovery temperature of the shape-memory polymer and less than the melting point thereof. That is, the normally open valve 4 is in the open state having a penetration shape in a steady state.

Moreover, the sheet 3 is restored to the flat shape after the heating, and therefore, the normally open valve 4 is deformed to the closed state in which the flow of the fluid is blocked.

The shape-memory polymer constituting the normally open valve 4 is not particularly limited, and examples thereof include polymeric materials such as elastomers having shape-memory property.

As specific examples of the elastomers having the shape-memory property, polymers such as polyurethane, polyisoprene, polyethylene, polynorbornene, and styrene-butadiene copolymers; epoxy resins, phenolic resins, acrylic resins, polyester, and melanin resin; and polycaprolactone, polyvinyl chloride, polystyrene, polybutylene succinate, polyethylene terephthalate, polybutylene terephthalate, and polyphenylene sulfide are cross-linked through a chemical cross-linking technique by heat using peroxides such as organic peroxides or benzoyl peroxide.

### [Normally Closed Valve]

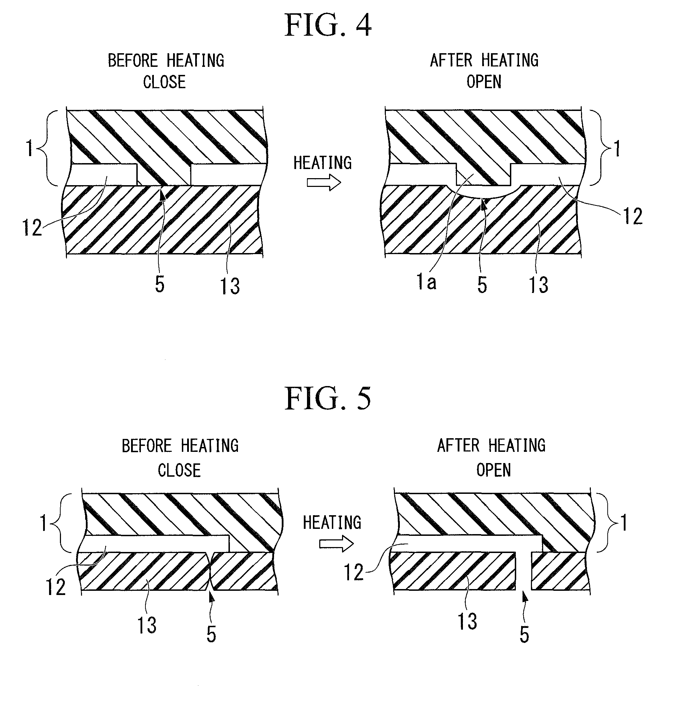

FIG. 4 is a schematic cross-sectional view showing a second embodiment of a valve of the present invention. The valve of the present embodiment is a normally closed valve 5 which is deformed from a closed state, in which the flow of fluid in a flow channel 12 is blocked, to an open state, in which the fluid is made to flow through the flow channel, by being heated.

### (Recess-shaped Valve)

As shown in FIG. 4, a flow channel 12 is formed by laminating a flow channel forming layer 1 and a sheet 13. Any hierarchical relationship between the sheet and the flow channel forming layer may be adopted even in the present embodiment.

The flow channel forming layer 1 has a barrier 1a and the flow of fluid in the flow channel 12 is blocked by the barrier 1a. On the contrary, the normally closed valve 5 has a flat shape in a steady state and is in a state in which the flow of the fluid is blocked.

The sheet 13 formed of the shape-memory polymer retains the recess shape at the time of molding. In FIG. 4, the normally closed valve 5 is molded in a flat shape by applying an external force at a temperature within a range of higher than or equal to a shape recovery temperature of the shape-memory polymer and less than the melting point thereof.

After heating, the normally closed valve 5 is in an open state in which the fluid flows through the flow channel 12 and which has a shape for bypassing the closed state in which the flow of the fluid is blocked. Here, in FIG. 4, the open state of the normally closed valve 5 is a state having a recess shape for bypassing the closed state.

Accordingly, the sheet 13 is restored to the recess shape after the heating, and therefore, the normally closed valve 5 is deformed to the open state in which the fluid flows through the flow channel.

### (Penetration-shaped Valve)

In addition, as shown in FIG. 5, the open state of the normally closed valve 5 may be a state having a penetration shape for bypassing the closed state. In FIG. 5, the normally closed valve 5 is molded in a flat shape by applying an external force at a temperature within a range of higher than or equal to a shape recovery temperature of the shape-memory polymer and less than the melting point thereof. That is, the normally closed valve 5 is in the closed state having a flat shape in a steady state.

Moreover, the sheet 3 is restored to the penetration shape after the heating, and therefore, the normally closed valve 5 is deformed to the open state in which the fluid flows through the flow channel.

Examples of the shape-memory polymer constituting the normally closed valve 5 include the same materials as that in the shape-memory polymer constituting the normally open valve 4.

### [Series Valve]

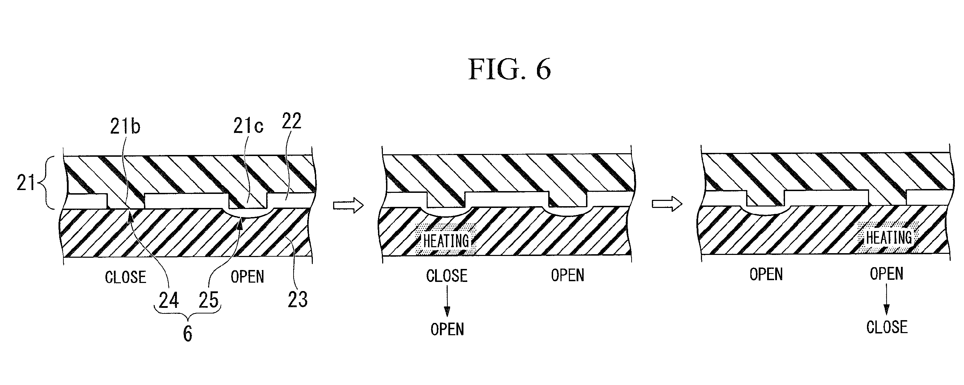

FIG. 6 is a schematic cross-sectional view showing a third embodiment of a valve of the present invention. For example, the valve of the present embodiment is a series valve 6 which is formed by disposing a normally closed valve 24 and a normally open valve 25 from an upstream side of the flow channel 22 in this order. In addition, the valve of the present embodiment is a series valve in which the normally closed valve 24 and the normally open valve 25 are disposed in series along the flow channel 22. The valve of the present embodiment may be a series valve in which a normally open valve 25 and a normally closed valve 24 are disposed from an upstream side of the flow channel 22 in this order.

A case, in which the open states of the normally closed valve 24 and the normally open valve 25 are in a recess shape, is described in the present embodiment. However, both the open states of the normally closed valve and the normally open valve may be in a penetration shape or may be in a combination of the recess shape and the penetration shape.

As shown in FIG. 6, the flow channel 22 is formed by laminating a flow channel forming layer 21 and a sheet 23. Any hierarchical relationship between the sheet and the flow channel forming layer may be adopted even in the present embodiment.

The flow channel forming layer 21 has a barrier 21b and a barrier 21c from an upstream side in this order. The normally closed valve 24 and the normally open valve 25 are respectively provided immediately under the barrier 21 b and the barrier 21 c as valves respectively corresponding to the barriers.

The flow of the fluid is first blocked by the barrier 21b positioned at an upstream side of the flow channel 22. The normally closed valve 24 has a flat shape in a steady state and the flow of the fluid remains in a blocked state. Accordingly, the series valve 6 enters an overall closed state.

Next, in the sheet 23, the normally closed valve 24 is deformed to an open state in which the fluid flows through the flow channel by heating a side which does not come into contact with the flow channel forming layer 21 at a site in which the normally closed valve 24 is provided. The fluid which bypassed the barrier 21b can further bypass the barrier 21c positioned at a downstream side by the normally open valve 25 being in the open state. Accordingly, the series valve 6 enters the overall open state.

Next, in the sheet 23, the normally open valve 25 is deformed to a closed state in which the flow of the fluid is blocked by heating a side which does not come into contact with the flow channel forming layer 21 at a site in which the normally open valve 25 is provided. Accordingly, the flow of the fluid which bypassed the barrier 21b is blocked by the barrier 21c due to the change of the state of the normally open valve 25 to the closed state. Accordingly, the series valve 6 enters the overall closed state.

In general, it is considered that, in a valve formed of the shape-memory polymer, the change of the open and closed states are irreversible because of the characteristics of the shape-memory polymer. However, according to the valve of the present embodiments, it is possible to flexibly control the flow of the fluid by deforming the state of the valve from a closed state to an open state and further deforming the state of the valve from an open state to a closed state.

According to the valve of the present embodiments, it is possible to simply manufacture the valve by causing the sheet formed of the shape-memory polymer to retain the shape, and to simply and freely control the flow of the fluid simply by performing a heating manipulation (temperature manipulation).

### <Microstructure>

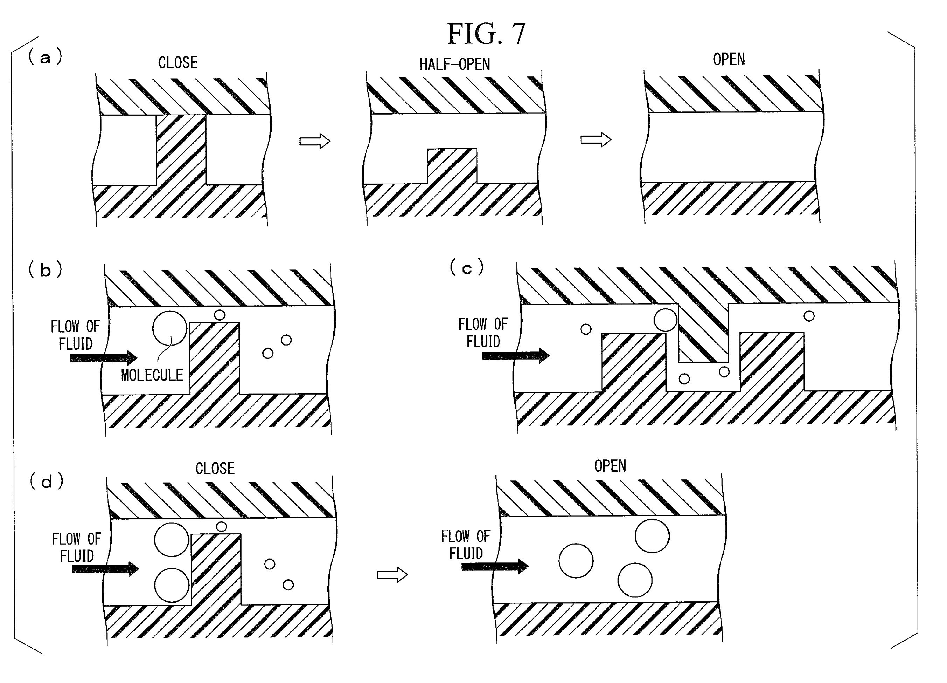

The microstructure of the present embodiments is formed of a shape-memory polymer disposed on a flow channel. The shape of the shape-memory polymer is not particularly limited, and may be the above-described normally open valve, the normally closed valve, series valve, and the like. The microstructure of the present embodiments can be molded through the same method as that of the above-described normally open valve, the normally closed valve, the series valve, and the like. It is preferable that the microstructure of the present embodiments be formed of a normally open valve in a state of being partially closed, or formed of a normally closed valve in a state of being partially opened by appropriately heating these valves, for example. In this manner, as shown in FIG. 7(a), it is possible to limit the width and the depth of the flow channel and to freely and selectively control the flow of the fluid by having a valve in various "half-open" states.

According to the microstructure of the present embodiments, it is possible to sort molecules having desired sizes in the fluid as shown in FIG. 7(b) even without providing a separate gel permeation column device or the like in the microfluidic device. For example, according to the structure of the present embodiments, it is possible to sort red blood cells and circulating tumor cells (CTCs) in blood by size difference. In addition, as shown in FIG. 7(c), it is possible to sort molecules having desired sizes in liquid by adjusting the distance between the microstructures in advance when a plurality of microstructures are disposed in the flow channel.

In addition, according to the microstructure of the present embodiments, it is possible to freely and selectively control the flow of the fluid by controlling the deformation amount of the microstructure in accordance with a process. As an example, as shown in FIG. 7(d), it is possible to make molecules, which has been held, flow by sorting a molecule having a desired size in the fluid and by temporarily holding the sorted molecules using the microstructure, and then, by making the microstructure to be in a completely open state by heating or the like.

In this manner, the microstructure in the present embodiments can function as a filter in a flow channel by selectively controlling the deformation amount of the structure.

As described above, the flow channel in the fluidic device of the present embodiments is formed by laminating the flow channel forming layer and the sheet.

First, a valve sheet and the flow channel forming layer will be described.

### [Valve Sheet]

The valve sheet of the present embodiments is a valve sheet on which a valve formed of a shape-memory polymer is disposed. The valve is at least a type selected from a group consisting of a normally open valve of which the state is deformed from an open state in which fluid flows through a flow channel to a closed state in which the flow of the fluid is blocked, by being heated; a normally closed valve of which the state is deformed from the closed state in which the flow of the fluid in the flow channel is blocked to the open state in which the fluid flows through the flow channel, by being heated; and a series valve which is formed by disposing the normally closed valve and the normally open valve in series.

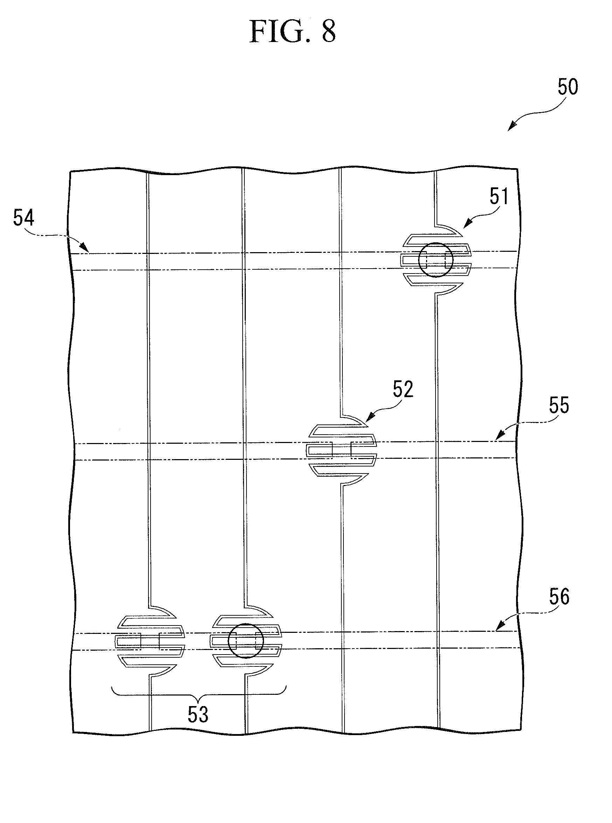

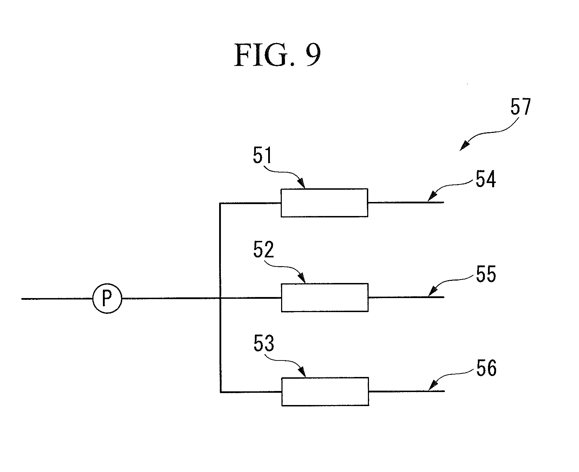

FIG. 8 is a front view showing a basic configuration of a valve sheet 50 in the present embodiments and FIG. 9 is a schematic view showing a basic configuration of a microfluidic device 57 using the valve sheet 50 of the present embodiments.

As shown in FIG. 8, in the valve sheet 50 of the present embodiments, a normally open valve 51, normally closed valve 52, and a series valve 53 are disposed at a position at which it is possible to adjust the flow of liquid in flow channels 54, 55, and 56 provided in microfluidic device 57 shown in FIG. 9. FIG. 8 shows flow channels controlled by each valve and corresponding positions of wires for a heater for heating each valve.

In FIG. 8, valve sheets formed by disposing each one type of these valves are shown. However, the number or the types of valves to be disposed is not particularly limited, and is appropriately combined depending on the corresponding micro flow channel device.

The material of the valve sheet 50 of the present embodiments is not particularly limited as long as the valve constituting the sheet is formed of a shape-memory polymer. However, it is preferable that the portion except for the valve also use the shape-memory polymer in view of simple manufacturing and stable security of open and close functions of the valve.

As examples of the shape-memory polymers as the material of the valve sheet 50, elastomers which have the shape-memory property and in which above-described polymers such as polyurethane, polyisoprene, polyethylene, polynorbornene, and styrene-butadiene copolymer; epoxy resins, phenolic resins, acrylic resins, polyester, and melanin resin; and polycaprolactone, polyvinyl chloride, polystyrene, polybutylene succinate, polyethylene terephthalate, polybutylene terephthalate, and polyphenylene sulfide are cross-linked through a chemical cross-linking technique by heat using peroxides such as organic peroxides or benzoyl peroxide.

### [Method of Manufacturing Valve Sheet]

### (First Embodiment (Method of Manufacturing Recess-shaped Valve Sheet))

The method of manufacturing the valve sheet of the present embodiment includes: a step of forming a first recess portion on a sheet formed of a shape-memory polymer through molding processing or machining at a temperature less than the melting point of the shape-memory polymer, making the first recess portion flat by applying an external force to the first recess portion at a temperature within a range of higher than or equal to a shape recovery temperature of the shape-memory polymer and less than the melting point thereof, and forming a normally closed valve on the sheet; and/or a step of providing a second recess portion by applying an external force on the sheet at a temperature within the range of higher than or equal to the shape recovery temperature of the shape-memory polymer and less than the melting point thereof and forming a normally open valve on the sheet.

In this manner, the method of manufacturing the valve sheet of the present embodiment has the step of forming the normally closed valve on the sheet and/or the step of forming the normally open valve on the sheet. The steps are appropriately combined depending on the number or the types of valves arranged on the valve sheet. Hereinafter, each step will be described.

### (Step of Molding Normally Closed Valve)

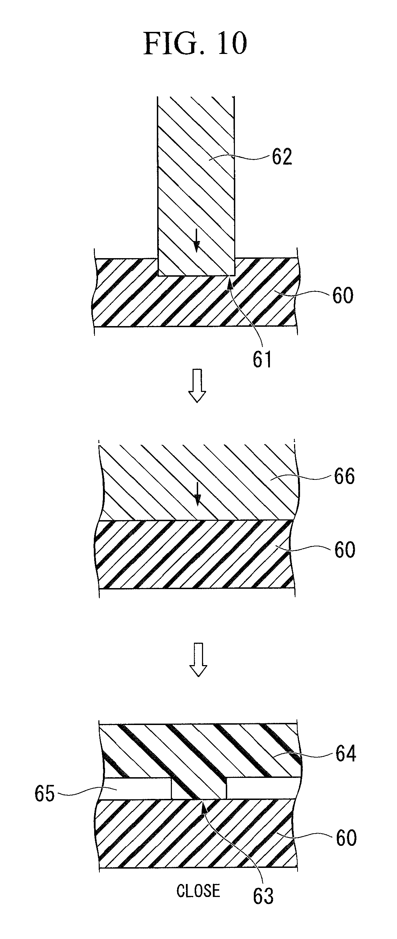

As shown in FIG. 10, in the step of forming the normally closed valve, first, a first recess portion 61 is provided on a sheet 60 formed of a shape-memory polymer through molding processing or machining at a temperature less than the melting point of the shape-memory polymer. Examples of the molding processing include injection molding or processing by hot embossing. Examples of the machining include cutting using an end mill 62. The sheet 60 retains the recess shape of the first recess portion 61.

Next, the first recess portion 61 is made flat by applying an external force to the first recess portion 61 at a temperature within a range of higher than or equal to a shape recovery temperature of the shape-memory polymer and less than the melting point thereof using a flat sheet mold 66, and a normally closed valve 63 is molded on the sheet 60. A flow channel 65 is formed by bonding (or joining) the sheet 60 and the flow channel forming layer 64.

### (Step of Molding Normally Open Valve)

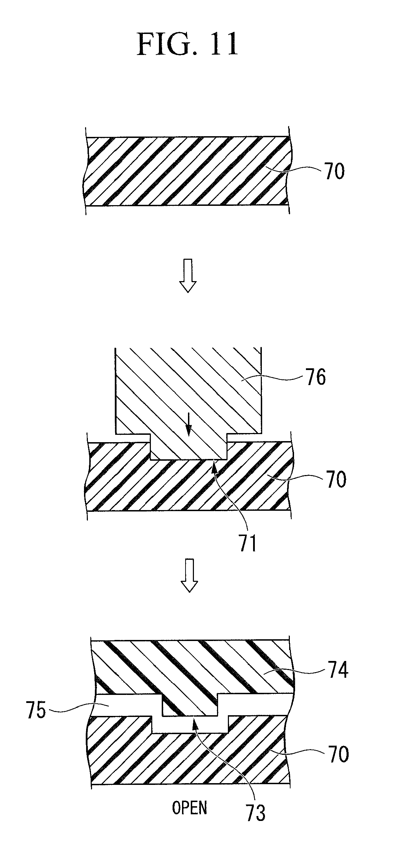

As shown in FIG. 11, in the step of molding the normally open valve, a second recess portion 71 is provided on a sheet 70 formed of shape-memory polymer by applying an external force on the sheet 70 using a mold 76 having a convex shape at a temperature within the range of higher than or equal to the shape recovery temperature of the shape-memory polymer and less than the melting point thereof and a normally open valve 73 is molded on the sheet 70. The sheet 70 retains the flat shape at the time of forming the sheet. A flow channel 75 is formed by bonding (or joining) the sheet 70 and the flow channel forming layer 74.

### (Second Embodiment (Method of Manufacturing Penetration-shaped Valve Sheet))

The method of manufacturing the valve sheet of the present embodiment includes: a step of forming a first penetration hole on a sheet formed of a shape-memory polymer through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point thereof, and molding a normally closed valve on the sheet; and/or a step of providing a second penetration hole by applying an external force on the sheet at a temperature within the range of higher than or equal to the shape recovery temperature of the shape-memory polymer and less than the melting point thereof and molding a normally open valve on the sheet.

Similarly to the first embodiment, the method of manufacturing the valve sheet of the present embodiment has the step of molding the normally closed valve on the sheet and/or the step of molding the normally open valve on the sheet. The steps are appropriately combined depending on the number or the types of valves arranged on the valve sheet. Hereinafter, each step will be described.

### (Step of Molding Normally Closed Valve)

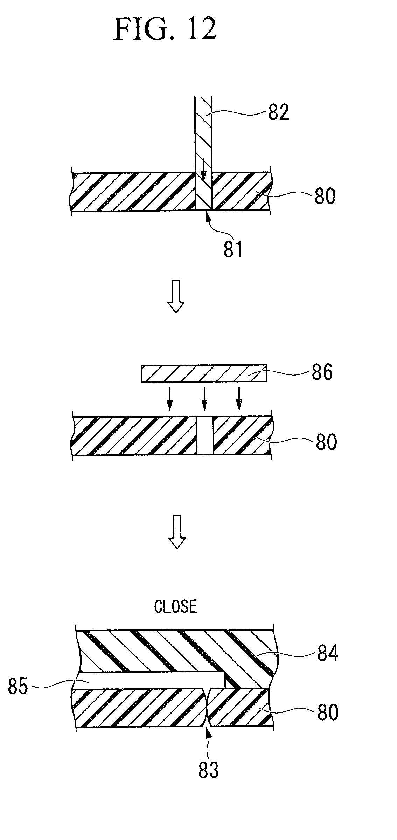

As shown in FIG. 12, in the step of molding the normally closed valve, first, a first penetration hole 81 is molded on a sheet 80 formed of a shape-memory polymer through molding processing or machining at a temperature less than the melting point of the shape-memory polymer. The machining is not particularly limited, and examples thereof include cutting using an end mill 82. The sheet 80 retains the penetration shape of the first penetration hole 81.

Next, the first penetration hole 81 is made flat by applying an external force to the first penetration hole 81 at a temperature within a range of higher than or equal to a shape recovery temperature of the shape-memory polymer and less than the melting point thereof using a flat sheet mold 86, and a normally closed valve 83 is molded on the sheet 80. A flow channel 85 is formed by bonding (or joining) the sheet 80 and the flow channel forming layer 84.

### (Step of Molding Normally Open Valve)

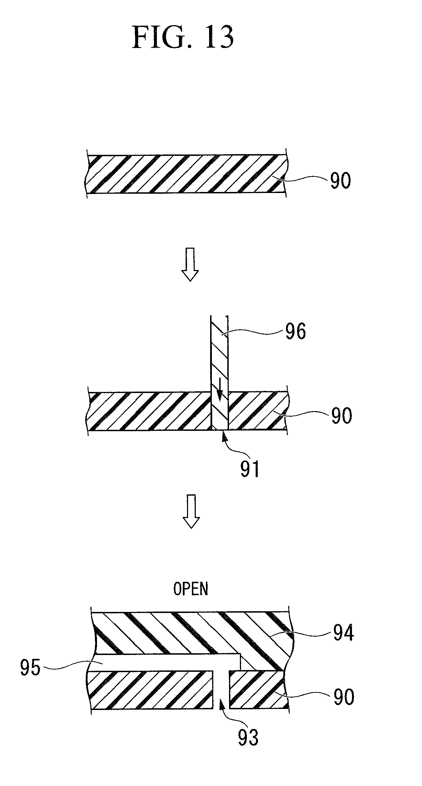

As shown in FIG. 13, in the step of molding the normally open valve, a second penetration hole 91 is provided on a sheet 90 formed of shape-memory polymer by applying an external force on the sheet 90, using a mold 96 having a bar shape, at a temperature within the range of higher than or equal to the shape recovery temperature of the shape-memory polymer and less than the melting point thereof and a normally open valve 93 is molded on the sheet 90. The sheet 90 retains the flat shape at the time of forming the sheet. A flow channel 95 is formed by bonding (or joining) the sheet 90 and the flow channel forming layer 94.

### [Flow Channel Forming Layer]

Next, the flow channel forming layer used in the present embodiments will be described. The flow channel forming layer constitutes the microfluidic device of the present embodiments together with the valve sheet of the present embodiments. The flow channel forming layer is not particularly limited, but it is preferable that the flow channel forming layer be a resin sheet with a flow channel in view of simple manufacturing of the microfluidic device.

Examples of the material of the resin sheet with a flow channel include polyisoprene, polybutadiene, polychloroprene, polyisobutylene, poly(styrene-butadiene-styrene), polyurethane, and silicone polymers; poly (bis(fluoroalkoxy)phosphazene) (PNF, Eypel-F), poly(carborane-siloxane) (Dexsil), poly(acrylonitrile-butadiene) (nitrile rubber), poly(1-butene), poly(chlorotrifluoroethylene-vinylidene fluoride) copolymer (Kel-F), poly(ethyl vinyl ether), poly(vinylidene fluoride), poly (vinylidene fluoride-hexafluoropropylene) copolymer (Viton), elastomer composition of polyvinyl chloride (PVC), polysulfone, polycarbonate, polymethyl methacrylate (PMMA), and polytetrafluoroethylene; chlorosilane, methylsilane, ethylsilane, phenyl silane, and polydimethylsiloxane (PDMS).

The size of the flow channel formed on the resin sheet formed of the materials is not particularly limited as long as it is possible to control the flow of the fluid using the valve of the present embodiments, and preferred examples thereof include the following sizes.

The ratio of the width to the depth is preferably 0.1:1 to 100:1, more preferably 1:1 to 50:1, and particularly preferably 2:1 to 20:1, and most preferably 3:1 to 15:1.

Examples of the width of the flow channel include 0.01 µm to 1000 µm, 0.05 µm to 1000 µm, 0.2 µm to 500 µm, 1 to 250 µm, and 10 µm to 200 µm. In addition, examples of the width of the flow channel further include 0.01 mm to 100 mm, 0.05 mm to 100 mm, 0.2 mm to 50 mm, 1 mm to 25 mm, and 1.5 mm to 15 mm.

Examples of the depth of the flow channel include 0.01 µm to 1000 µm, 0.05 µm to 500 µm, 0.2 µm to 250 µm, 1 µm to 100 µm, and 2 µm to 20 µm. In addition, examples of the depth of the flow channel further include 0.01 mm to 100 mm, 0.05 mm to 100 mm, 0.2 mm to 50 mm, 1 mm to 25 mm, and 1.5 mm to 15 mm.

### <Microfluidic Device>

The microfluidic device of the present embodiments is a microfluidic device provided with a valve formed of a shape-memory polymer disposed in a flow channel. The valve is at least one selected from a group consisting of a normally open valve of which the state is deformed from an open state in which fluid flows through the flow channel to a closed state in which the flow of the fluid is blocked, by being heated; a normally closed valve of which the state is deformed from the closed state in which the flow of the fluid in the flow channel is blocked to the open state in which the fluid flows through the flow channel, by being heated; and a series valve which is formed by disposing the normally closed valve and the normally open valve in series from an upstream side of the flow channel in this order.

The microfluidic device of the present embodiments is formed by bonding (or joining) the above-described valve sheet and flow channel forming layer. In addition, the microfluidic device of the present embodiments includes means (controlling unit, controller) for controlling the open state and the closed state by changing the temperature of at least a portion of the shape-memory polymer through heating or the like.

Hereinafter, the micro flow channel device of the present embodiments will be described.

### (First Embodiment)

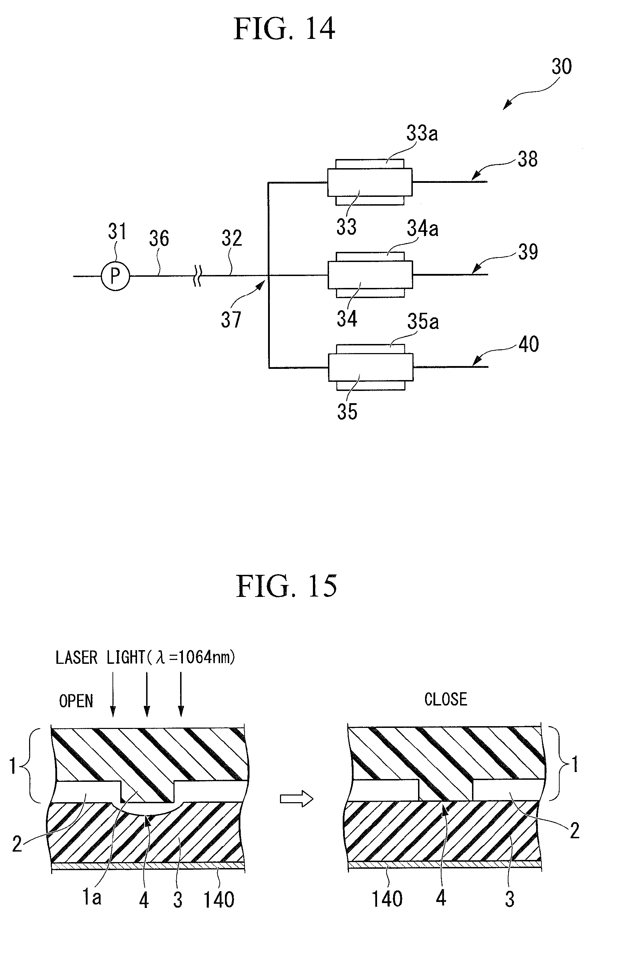

FIG. 14 is a schematic view showing a basic configuration of a microfluidic device 30 of the present embodiment. As shown in FIG. 14, the microfluidic device 30 of the present embodiment includes a driving source 31, a branch flow channel 32, a normally open valve 33, a normally closed valve 34, and a series valve 35. The branch flow channel 32 is configured to have an upstream flow channel 36 which is a flow channel further on an upstream side than a branch point 37, and downstream flow channels 38, 39, and 40 which are flow channels further on a downstream side than the branch point 37.

The driving source 31 is connected to the upstream flow channel 36 and sends fluid to the downstream side using a predetermined extrusion force. Examples of the driving source 31 include a syringe pump or the like.

The normally open valve 33, the normally closed valve 34, and the series valve 35 are respectively provided in the downstream flow channels 38, 39 and 40 and are arranged at positions at which it is possible to selectively (locally) adjust the flow of the fluid in each flow channel.

The microfluidic device 30 of the present embodiment is used in a recovery portion of a purified specimen when purifying biomolecules such as nucleic acids from a specimen such as blood.

Dissolving liquid of the specimen washed away by driving liquid such as buffer liquid passes through a purification device such as a column, which exists in the upstream flow channel 36, but is not shown in the drawing, and passes through the branch point 37, by the driving source 31. Substances which first pass through the branch point 37 in the dissolving liquid of the specimen are unnecessary substances. Therefore, the substances pass through the downstream flow channel 38 in which the normally open valve 33 in an open state are provided, and are discharged. Next, the normally open valve 33 enters a closed state by heating means (heating unit, heater) 33a which is installed in the normally open valve 33.

Next, the series valve 35 enters an open state by the heating means 35a installed in the series valve 35. Substances which secondarily pass through the branch point 37 in the dissolving liquid of the specimen pass through a downstream flow channel 40 and are collected as a first fractional substance.

Next, the series valve 35 enters a closed state by the heating means 35a and the normally closed valve 34 enters an open state by the heating means 34a which is installed in the normally closed valve 34. Substances which thirdly pass through the branch point 37 in the dissolving liquid of the specimen pass through a downstream flow channel 39 and are collected as a second fractional substance.

In this way, according to the microfluidic device 30 of the present embodiment, it is possible to efficiently fractionate dissolving liquid of a specimen in a purified specimen recovery unit.

Here, the heating means 33a, 34a, and 35a respectively installed in the normally open valve 33, the normally closed valve 34, and the series valve 35 may be heating by a heater or heating through laser light irradiation. In addition, the heating means 33a, 34a, and 35a may be heating using an electrode.

When the heating means 33a, 34a, and 35a are heating through the laser light irradiation, as shown in FIG. 15, it is preferable that a photothermal conversion layer 140 be provided on a surface side, of the valve sheet, opposite to a surface which comes into contact with the flow channel forming layer.

The photothermal conversion layer 140 includes a light absorbing agent. Radiant energy, which is obtained such that the photothermal conversion layer 140 is irradiated with laser light, is absorbed by the light absorbing agent, and then, is converted to heat energy. The valve is heated and deformed by the generated heat energy. That is, it is preferable that the microfluidic device of the present embodiment include heating means using the light absorbing agent.

The heating means in the present embodiment may selectively (locally) heat the valve sheet, under which the photothermal conversion layer 140 is provided, through the laser light irradiation using a mask, for example.

As the light absorbing agent, it is preferable to use a light absorbing agent which absorbs radiant energy having a wavelength to be used. The wavelength of the radiant energy is preferably 300 nm to 2000 nm and more preferably 300 nm to 1500 nm.

Examples of the light absorbing agent include particulate metal powders such as carbon black, graphite powder, iron, aluminum, copper, nickel, cobalt, manganese, chromium, zinc, and tellurium; metal oxide powders such as black titanium oxide; and dyes or pigments such as aromatic diamine-based metal complexes, aliphatic diamine-based metal complexes, aromatic dithiol-based metal complexes, mercaptophenol-based metal complexes, squarylium-based compounds, cyanine-based pigments, methine-based pigments, naphthoquinone-based pigments, and anthraquinone-based pigments. The photothermal conversion layer 140 may be formed of the dyes or pigments and resin. The resin used in the photothermal conversion layer 140 is not particularly limited, and the same shape-memory polymer as that used in the valve sheet may be used.

In addition, in the photothermal conversion layer 140, the light absorbing agents may be formed in a film shape, for example, a metal evaporated film.

In addition, the valve sheet and the photothermal conversion layer 140 are separately shown in FIG. 15. However, the valve sheet itself may be formed of the above-described shape-memory polymer and the light absorbing agent.

The concentration of the light absorbing agent in the photothermal conversion layer 140 varies depending on the type of light absorbing agent, the form of particles, the dispersion degree, and the like, but is preferably 5 volume% to 70 volume%. When the concentration thereof is higher than or equal to 5 volume%, the valve is efficiently deformed by heat generated by the photothermal conversion layer 140. The concentration thereof is lower than or equal to 70 volume, the film-forming property of the photothermal conversion layer 140 and the bonding efficiency between the photothermal conversion layer and the valve sheet are improved.

The thickness of the photothermal conversion layer is preferably 0.1 µm to 5 µm. When the thickness of the photothermal conversion layer is 0.1 µm, the concentration of the light absorbing agent which is required for performing sufficient light absorption is prevented from being too high, and therefore, the film-forming property of the photothermal conversion layer and the bonding efficiency between the photothermal conversion layer and the valve sheet are improved. When the thickness of the photothermal conversion layer is less than or equal to 5 µm, the light transmittance in the photothermal conversion layer is improved, and therefore, the heat generation efficiency is improved.

It is possible to further control the change amount of the shape-memory polymer by controlling the heating condition when an electrode is provided as heating means. For example, the electrode is configured such that an electric resistance value reduces from an upstream side of a flow channel toward a downstream side thereof.

### (Second Embodiment)

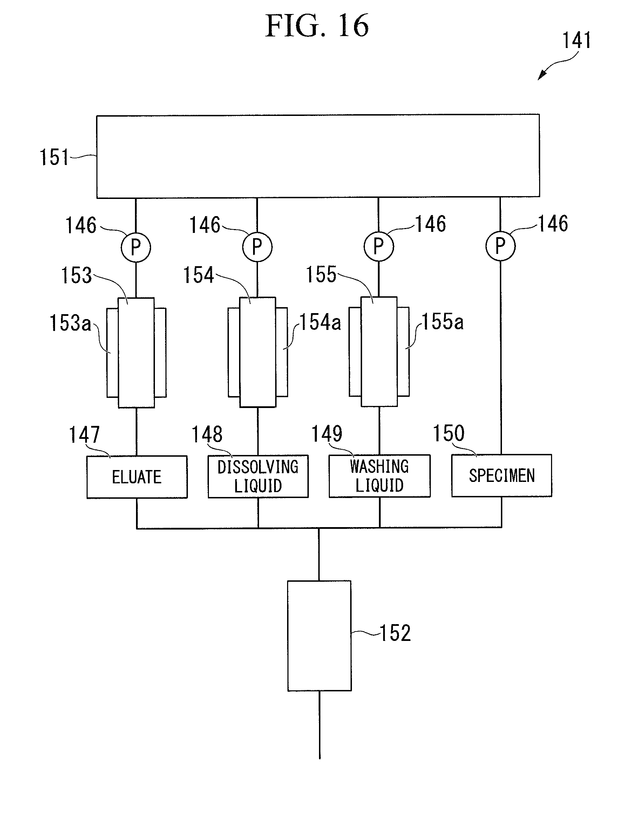

FIG. 16 is a schematic view showing a basic configuration of the microfluidic device 141 of the present embodiment. The microfluidic device 141 of the present embodiment is used in an introduction portion of a purification device when purifying biomolecules such as nucleic acids from a specimen such as blood.

As shown in FIG. 16, a valve sheet 141 of the present embodiment has four liquid reservoir units 147, 148, 149, and 150 in a downstream side of a driving source 146. Eluate, dissolving liquid, washing liquid and a liquid-like specimen are respectively stored in the liquid reservoir units 147, 148, 149, and 150. Moreover, driving liquid is stored in a liquid reservoir unit 151 which is positioned upstream of the driving source 146. Furthermore, flow channels in the upstream side of the liquid reservoir units 147, 148, and 149 are respectively provided with a normally closed valve 153, a normally open valve 154, and a series valve 155. The driving liquid, which is extruded from the driving source 146, selectively extrudes each liquid which is stored in the liquid reservoir units positioned downstream of the valves due to the opening and closing of the valves. Accordingly, each liquid is selectively extruded to a purification device 152 which is positioned downstream of the liquid reservoir units 147, 148, 149, and 150.

The liquid-like specimen, which is stored in the liquid reservoir unit 150, and a dissolving liquid, which is stored in the liquid reservoir unit 148 which is provided with the normally open valve 154 in an open state in the upstream side thereof, are extruded and pass through the purification device 152 which is configured to have a column or the like, by the driving source 146; and biomolecules in the specimen are dissolved and caught by the purification device 152. Next, the normally open valve 154 enters a closed state by heating means 154a which is installed in the normally open valve 154 and inflow of the dissolving liquid into the purification device 152 is stopped.

Next, the series valve 155 enters an open state by heating means 155a which is installed in the series valve 155 and the washing liquid stored in the liquid reservoir unit 155 flows into the purification device 152, and unnecessary substances are discharged from the purification device 152.

Next, the series valve 155 enters a closed state by the heating means 155a and the inflow of the washing liquid into the purification device 152 is stopped.

Next, the normally closed valve 153 enters an open state by heating means 153a which is installed in the normally closed valve 153, the eluate stored in the liquid reservoir unit 147 flows into the purification device 152, and a purified specimen is eluted from the purification device 152.

According to the microfluidic device 141 of the present embodiment, it is possible to efficiently purify the biomolecules in this manner.

### (Third Embodiment)

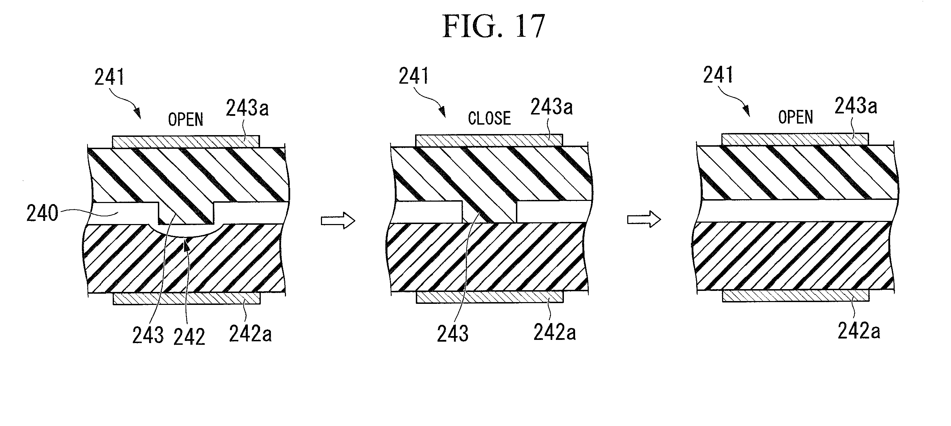

FIG. 17 is a schematic view showing a basic configuration of a microfluidic device 241 of the present embodiment. As shown in FIG. 17, the microfluidic device 241 of the present embodiment includes a normally open valve 242 which is disposed on a first surface; and a normally closed valve 243 which is disposed on a second surface facing the first surface. The normally open valve 242 and the normally closed valve 243 are disposed so as to face each other in the microfluidic device 241 of the present embodiment.

In a steady state, fluid bypasses the normally closed valve 243 functioning as a barrier through the normally open valve 242 formed at a bottom portion of a flow channel 240.

Next, the normally open valve 242 enters a closed state by heating means 242a which is installed at a bottom portion of the normally open valve 242 and the flow of the fluid is blocked by the normally closed valve 243.

Next, the normally closed valve 243 enters an open state by heating means 243a which is installed at an upper portion of the normally closed valve 243 and the blocked fluid starts to flow again.

According to the microfluidic device 241 of the present embodiment, it is possible to flexibly control the flow of the fluid since the microfluidic device has valves, of which, overall, the state is deformed from an open state to a closed state and is further deformed from the closed state to an open state.

### (Fourth Embodiment)

A microfluidic device of the present embodiment includes a pump configured to have a plurality of valves formed of a shape-memory polymer disposed in flow channels. In the present embodiment, the driving source 3 in FIG. 14 or the driving source 146 in FIG. 16 is configured to have two or more selected from a group consisting of the normally open valve, the normally closed valve, and the series valve of the above-described present embodiments. The types of the plurality of valves constituting the pump may be the same as or different from each other.

For example, when fluid is in a state of flowing from the liquid reservoir unit 151 at all times in FIG. 16, the plurality of valves function as driving sources (pumps) by controlling the open and closed states of the valves.

### (Fifth Embodiment)

A microfluidic device of the present embodiment includes heating means for controlling the deformation amount of the shape-memory polymer by controlling a heating condition to control the flow rate of fluid in a flow channel. Examples of the heating condition include time or heat amounts.

As an example, the width of the flow channel constituting the micro flow channel device is made to be of a millimeter size to strictly control the change amount of the shape-memory polymer depending on the change of the heating condition.

### [Method of Manufacturing Microfluidic Device]

The method of manufacturing the microfluidic device of the present embodiment which is formed of a valve sheet and a flow channel forming layer includes: a first step of manufacturing the valve sheet through the method of manufacturing the valve sheet including at least a step selected from a group consisting of a step of forming a first recess portion on a sheet formed of a shape-memory polymer through molding processing or machining at a temperature less than the melting point of the shape-memory polymer, making the first recess portion flat by applying an external force to the first recess portion at a temperature within a range of higher than or equal to a shape recovery temperature of the shape-memory polymer and less than the melting point thereof, and molding a first normally closed valve on the sheet, a step of providing a second recess portion by applying an external force on the sheet at a temperature within the range of higher than or equal to the shape recovery temperature of the shape-memory polymer and less than the melting point thereof and molding a first normally open valve on the sheet, a step of forming a first penetration hole through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point thereof, and molding a second normally closed valve on the sheet, and a step of providing a second penetration hole by applying an external force on the sheet at a temperature within the range of higher than or equal to the shape recovery temperature of the shape-memory polymer and less than the melting point thereof and molding a second normally open valve on the sheet; and a second step of laminating the valve sheet, which is manufactured in the first step, and the flow channel forming layer.

The first step is a step of manufacturing a valve sheet. The first step is a step of manufacturing the valve sheet by appropriately combining the group consisting of the above-described step of molding the normally closed valve (first normally closed valve) having a recess shape; the above-described step of molding the normally closed valve (second normally closed valve) having a penetration shape; the above-described step of molding the normally open valve (first normally open valve) having a recess shape; and the above-described step of molding the normally open valve (second normally open valve) having a penetration shape.

The first step also includes a step of forming a series valve which can be molded using the step of molding the normally closed valve and the step of molding the normally open valve.

The second step is a step of laminating the valve sheet, which is manufactured in the first step, and the flow channel forming layer. The flow channel forming layer is molded by a well-known manufacturing method using the above-described materials.

In the second step, it is preferable that the valve sheet and the flow channel forming layer be laminated, and then, be joined by positioning the valve sheet and the flow channel forming layer. The microfluidic device of the present embodiment is manufactured by the manufacturing method including the first step and the second step.

According to the method of manufacturing the micro flow channel device of the present embodiment, it is possible to simply manufacture the micro flow channel device at a low cost.

Hereinafter, the present invention will be described with reference to Examples, but is not limited to the following Examples.

### [Examples]

### «Example 1»

### <Production of Device Member>

### [Production of PCL (Polycaprolactone) Sheet]

Mixed liquid was prepared by mixing PCL, xylene, and benzoyl peroxide at a weight ratio of 40:60:1. The mixed liquid was sandwiched by two glass plates and was heated for 3 hours at 80°C in an oven for cross-linking.

A convex mold shape was formed on a portion of a surface coming into contact with a polymer of one of two glass plates and a recess shape was retained in a portion of the sheet at the time of cross-linking of the polymer.

The mixed liquid was taken out of the glass plate after the cross-linking and was dried after removing xylene using acetone. Then, a PCL sheet having the recess shape in a portion was obtained.

### [Production of Glass Substrate with Wiring for Heater]

After forming a metallic thin film through sputtering on a glass substrate, the metallic thin film was patterned through photolithography and wet etching to obtain a glass substrate with wiring for a heater.

### [Production of PDMS (Polydimethylsiloxane) Sheet with Flow Channel]

A PDMS polymer before cross-linking was poured onto a mold, heated for 1.5 hours at 80°C in an oven for cross-linking, and a PDMS sheet was obtained. The PDMS sheet was peeled from the mold, a hole was made on the PDMS sheet, and a tube was connected thereto to obtain a PDMS sheet with a flow channel.

### <Production of Device>

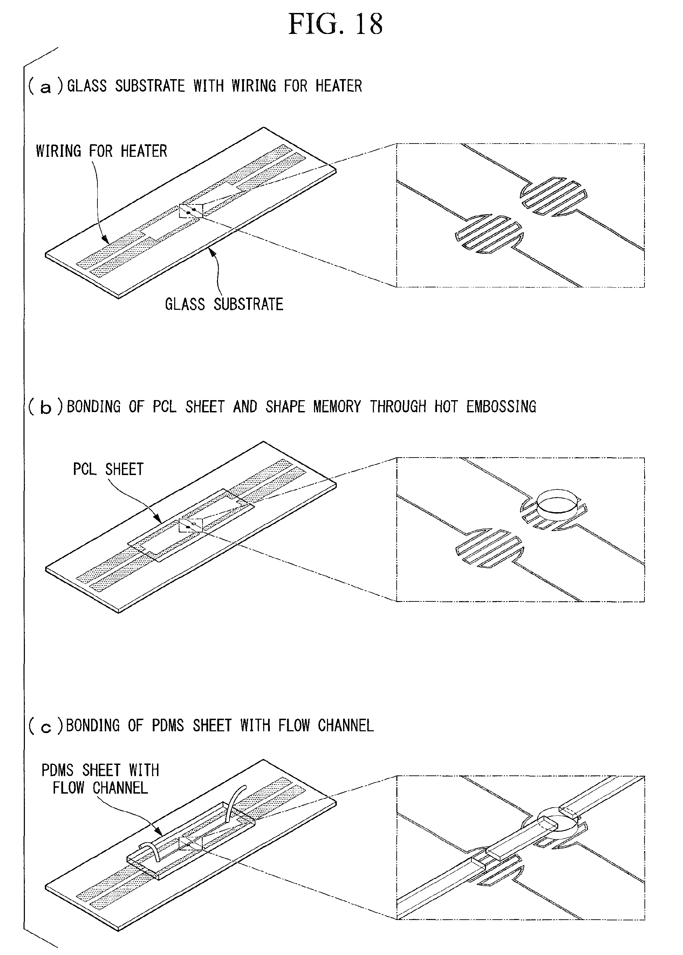

A device was produced using the produced device member (refer to FIG. 18(a)).

### [Shape Memory of PCL Sheet through Hot Embossing]

A PCL sheet having a recess shape in a portion was laminated on a glass plate with wiring for a heater such that a surface opposite to a surface having the recess shape comes into contact with the surface of the glass plate, and the PCL sheet was bonded to the glass plate with wiring for a heater by heating at 80°C.

Next, a mold for hot embossing was installed on the PCL sheet and a force of 10 kN was applied from the top of the mold at a temperature of 80°C to form a shape of a valve (normally open valve or normally closed valve) on the PCL sheet (refer to FIG. 18(b)).

The mold for hot embossing has a convex mold shape at a corresponding position which is different from the recess shape formed on the PCL sheet, and other regions have a flat shape.

For this reason, the recess shape formed on the PCL sheet before emboss processing is flattened and a normally closed valve is formed on the PCL sheet. In addition, a recess shape is formed on a region corresponding to the convex mold shape possessed by the mold for hot embossing, and a normally open valve is formed on the PCL sheet.

### [Assembly of Device]

The glass plate with wiring for a heater, to which a PCL sheet was bonded, and the PDMS sheet with a flow channel were irradiated with oxygen plasma (100 W, 25 Pa) for 10 seconds, and the bonded surface of the PCL sheet and the PDMS sheet with a flow channel was subjected to surface treatment. Next, the PDMS sheet with a flow channel was laminated on the PCL sheet of the glass plate with wiring for a heater, to which the PCL sheet was bonded, such that the surface formed with a flow channel of the PDMS sheet with a flow channel comes into contact with the surface of the PCL sheet bonded to the glass plate with wiring for a heater. Then, the PDMS sheet with a flow channel was bonded to the PCL sheet of the glass plate with wiring for a heater, to which the PCL sheet was bonded, to assemble the device (refer to FIG. 18(c)).

### [Confirming Operation of Device]

A current of 10 mA was made to flow through wiring for a heater in the device and PCL on the wiring for a heater was deformed by the heated heater. Alternatively, the device was placed on a hot plate which was heated to 80°C to deform PCL.

A solution containing a blue pigment was sent to a micro flow channel of the device using a syringe pump to observe the open and closed states of a valve using an optical microscope.

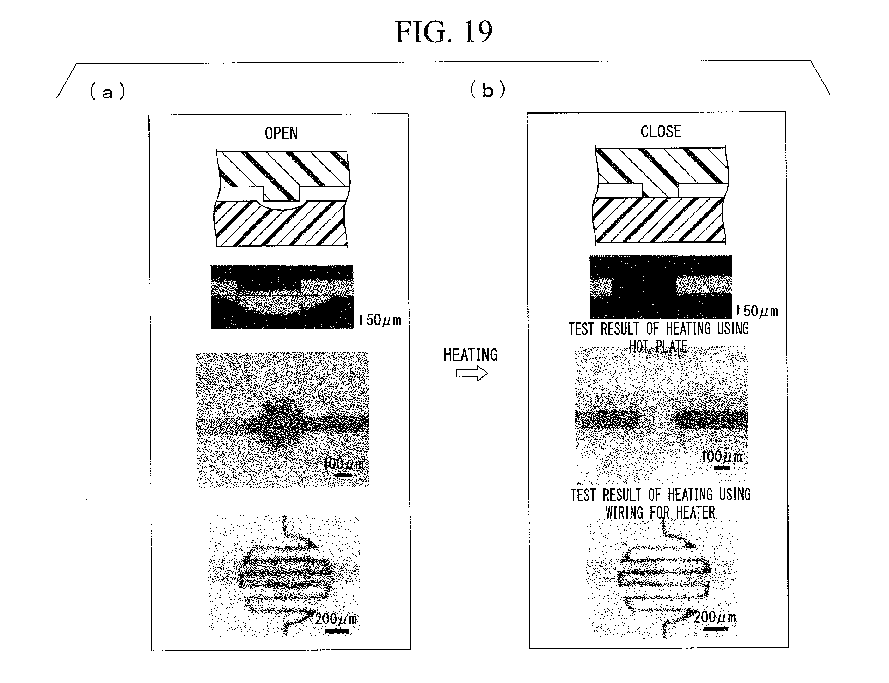

The upper section of FIG. 19(a) shows a cross-sectional view of a flow channel and a normally open valve before heating, and the middle and lower sections of FIG. 19(a) show front views of the flow channel and the normally open valve before heating.

The upper section of FIG. 19(b) shows a cross-sectional view of the flow channel and the normally open valve after heating, the middle section of FIG. 19(b) shows a front view of the flow channel and the normally open valve after heating by a hot plate, and the lower section of FIG. 19(b) shows a front view of the flow channel and the normally open valve after heating by a heater.

As shown in FIG. 19, it was confirmed that the normally open valve entered a closed state by the heating and the flow of a solution containing the blue pigment was blocked.

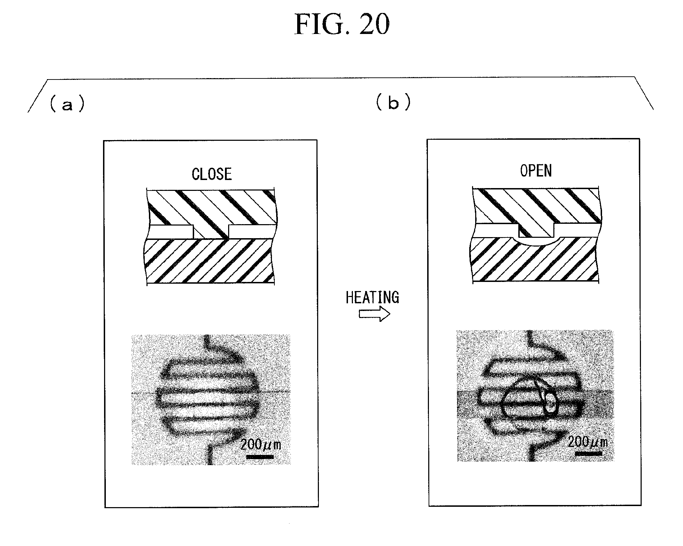

The upper section of FIG. 20(a) shows a cross-sectional view of a flow channel and a normally closed valve before heating, and the lower section of FIG. 20(a) shows a front view of the flow channel and the normally closed valve before heating.

The upper section of FIG. 20(b) shows a cross-sectional view of a flow channel and a normally open valve after heating, and the lower section of FIG. 20(b) shows a front view of the flow channel and the normally open valve after heating using a heater.

As shown in FIG. 20, the normally closed valve entered an open state by the heating and the flow of the solution containing the blue pigment was confirmed.

### «Example 2»

A device was assembled by the same method as that in Example 1 except that a glass substrate, on which a thin chromium layer was laminated, was used instead of the glass substrate with wiring for a heater and that a PCL sheet, on which a normally open valve was provided, and a PDMS sheet with a flow channel were laminated on the thin chromium layer in this order.

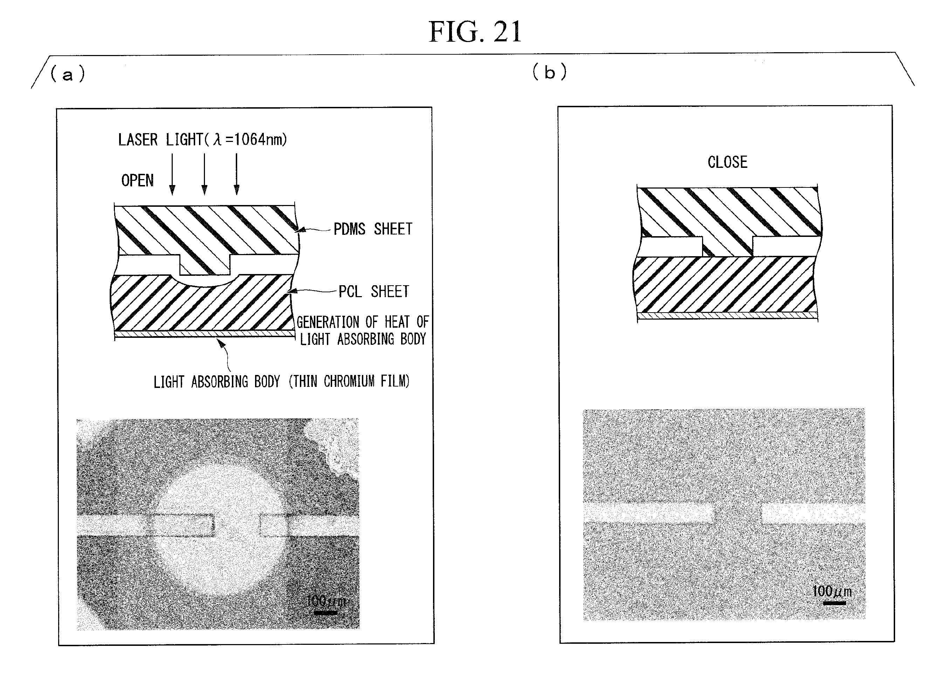

Next, as shown in the upper section of FIG. 21 (a), the region of the device on which the normally open valve was provided was irradiated with laser light of 1064 nm for 10 seconds from the top of the PDMS sheet using laser to heat the normally open valve. As shown in the lower sections of FIG. 21(a) and FIG. 21(b), the deformation of the normally open valve by the heating was observed using an optical microscope. As a result, it was confirmed that the normally open valve entered a closed state by the heating.

### «Example 3»

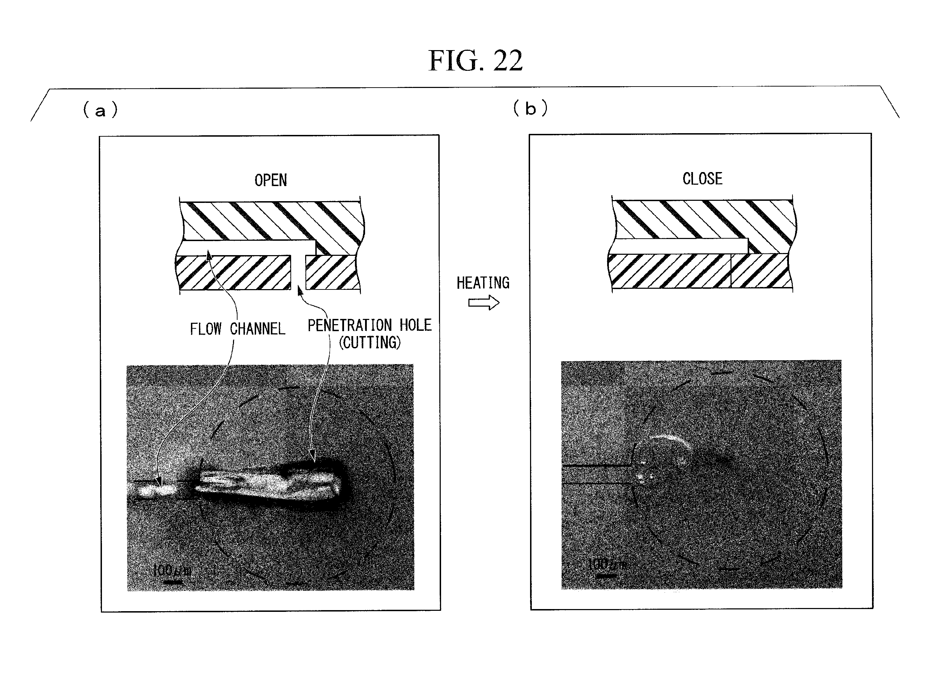

As shown in upper section of FIG. 22(a), a device was assembled by the same method as that in Example 1 except that a normally open valve with a penetration shape was provided on a PCL sheet. Next, PCL was deformed by heating the device using a heater.

As shown in the lower sections of FIG. 22(a) and 22(b), the deformation of the normally open valve by the heating was observed using an optical microscope. As a result, it was confirmed that the normally open valve entered a closed state by the heating.

### «Example 4»

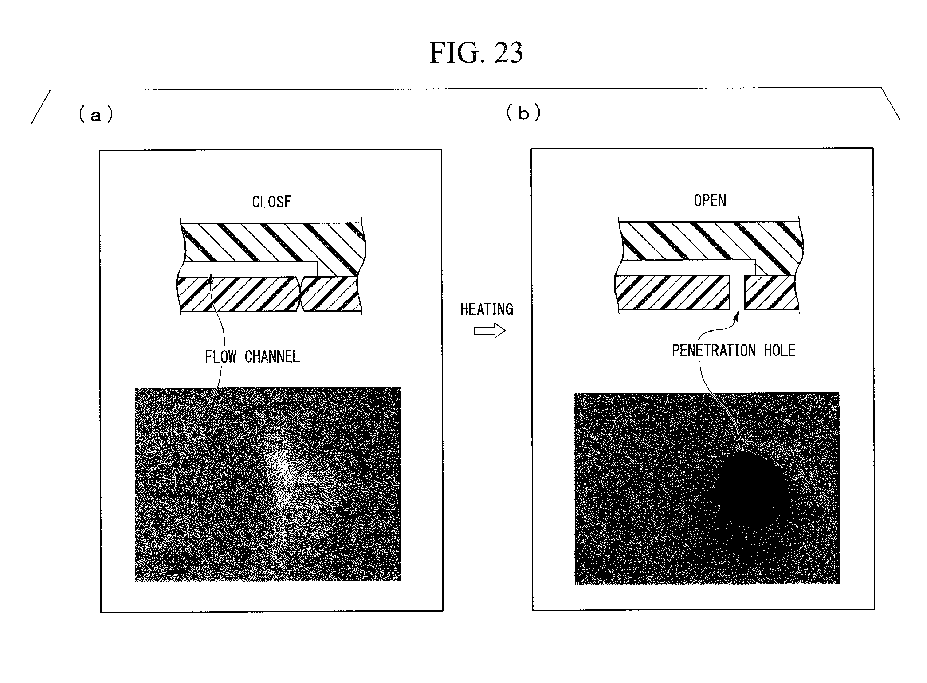

As shown in the upper section of FIG. 23(a), a device was assembled by the same method as that in Example 1 except that a normally closed valve with a penetration shape was provided on a PCL sheet. Next, PCL was deformed by heating the device using a heater.

As shown in the lower sections of FIG. 23(a) and 23(b), the deformation of the normally closed valve by the heating was observed using an optical microscope. As a result, it was confirmed that the normally closed valve entered an open state by the heating.

### «Example 5»

A device was assembled by the same method as that in Example 1, except that the width of the flow channel was scaled up to 2 mm and the whole size was scaled up at an equal ratio. The open and closed states of a valve were observed using an optical microscope by sending a solution containing a blue pigment to the flow channel of the device using a syringe pump.

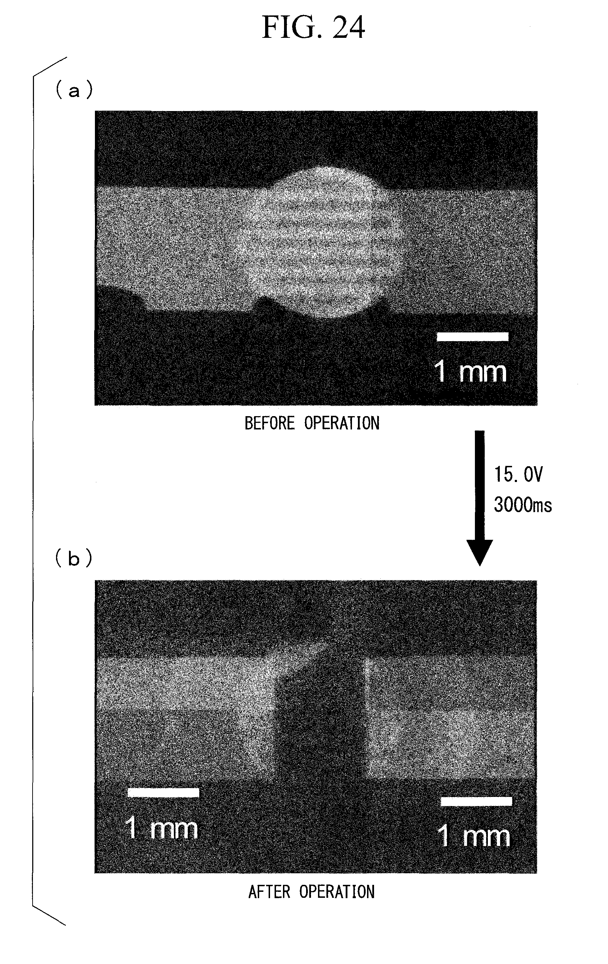

FIG. 24(a) shows a front view of a flow channel and a normally open valve before heating and FIG. 24(b) is a front view of the flow channel and the normally open valve after heating.

As shown in FIG. 24, it was confirmed that the normally open valve entered a closed state by heating and the flow of a solution containing a blue pigment was blocked.

### «Example 6»

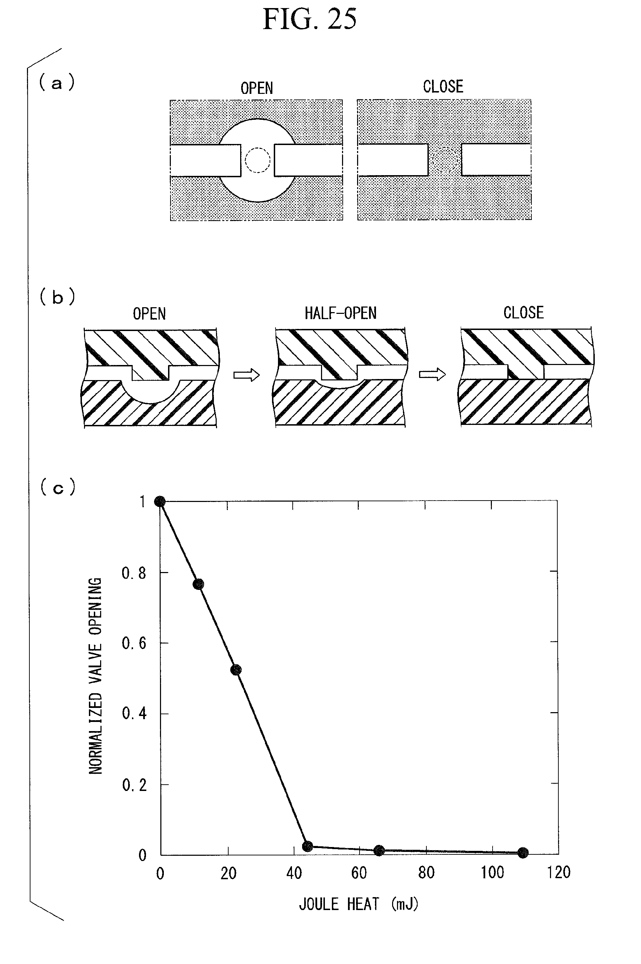

A device was produced by the same method as that in Example 5. A solution containing a fluorescent pigment (0.05 mass% of sulforhodamine B) was sent to a micro flow channel of the device using a syringe pump and heat amounts of 0 joule, 11 joules, 22 joules, 44 joules, 66 joules, and 110 joules were added to the flow channel using a micro heater. FIG. 25(a) shows an open state and a closed state of a normally open valve. In FIG. 25(a), the fluorescent strength in a region shown by a circle with a broken line was measured and the ratio of the fluorescent strength when each of the heat amounts was added was calculated by setting the fluorescent strength, in a state in which the heat amount is not added (0 joule), to 1. The result is shown in FIG. 25(c).

As shown in FIG. 25(c), it was confirmed that the fluorescent strength reduced depending on the added heat amount. As shown in FIG. 25(b), when the heat amount added to the flow channel was 0 joule, the normally open valve was in an open state, when the heat amount added to the flow channel was 22 joules (when normalized valve opening is 0.5), the normally open valve was in a "half-open" state, and when the heat amount added to the flow channel was 66 joules, the normally open valve was almost in a closed state. In this manner, it was confirmed that it is possible to control the flow rate of the fluid using the heat amount added to the flow channel.

From the above-described results, according to the present embodiments, it is obvious that it is possible to easily produce a valve and to easily control the flow of fluid without reducing the degree of freedom in design.

### [Industrial Applicability]

It is possible to provide a valve, which can be simply produced at a low cost and with which it is possible to simply and freely control the flow of fluid; a micro flow channel device which is provided with the valve; a valve sheet on which the valve is arranged; and a method of manufacturing the valve sheet and the micro flow channel device.

### DESCRIPTION OF THE REFERENCE SYMBOLS

1,21, 64, 74, 84, 94 ... flow channel forming layer; 1a, 21b, 21c ... barrier; 2, 12, 22, 65, 75, 85, 95 ... flow channel; 3, 13, 23, 60, 70, 80,90 ... sheet; 4, 25, 33, 51, 73,93, 154,242 ... normally open valve; 5,24,34, 52, 63, 83, 153, 243 ... normally closed valve; 6, 35, 53, 155 ... series valve; 30, 57, 141, 241 ... microfluidic device; 31, 146 ... driving source; 32 ... branch flow channel; 33a, 34a, 35a, 153a, 154a, 155a, 242a, 243a... heating means; 36 ... upstream flow channel; 37 ... branch point; 38, 39, 40 ... downstream flow channel; 50 ... valve sheet; 54, 55, 56 ... flow channel; 61 ... first recess portion; 62, 82 ... end mill; 66, 76, 86 ... mold; 71 ... second recess portion; 81 ... first penetration hole; 91 ... second penetration hole; 140 ... photothermal conversion layer; 147, 148, 149, 150, 151 ... liquid reservoir unit; 152 ... purification device

## Claims

1. A valve formed of a shape-memory polymer disposed in a flow channel,
wherein a flow of fluid in the flow channel is adjusted by deformation of the valve.

2. The valve according to claim 1,
wherein at least a portion of the shape-memory polymer forms at least a portion of the flow channel.

3. The valve according to claim 1 or 2,
wherein the valve is configured to be deformed to an open state in which the fluid flows through the flow channel or to a closed state in which the flow of the fluid is blocked, depending on the temperature change.

4. The valve according to claim 1 or 2,
wherein the valve is a normally open valve which is deformed from an open state in which the fluid flows through the flow channel to a closed state in which the flow of the fluid is blocked, by being heated.

5. The valve according to claim 1 or 2,
wherein the valve is a normally closed valve which is deformed from a closed state in which the flow of the fluid in the flow channel is blocked to an open state in which the fluid flows through the flow channel by being heated.

6. The valve according to claim 1 or 2,
wherein the valve is a series valve formed by disposing a normally closed valve, of which the state is deformed from a closed state in which the flow of the fluid in the flow channel is blocked to an open state in which the fluid flows through the flow channel by being heated, and a normally open valve, of which the state is deformed from the open state in which fluid flows through the flow channel to the closed state in which the flow of the fluid is blocked by being heated, in series.

7. The valve according to any one of claims 3 to 6,
wherein the open state is a state having a recess shape for bypassing the closed state.

8. The valve according to any one of claims 3 to 6,
wherein the open state is a state having a penetration shape for bypassing the closed state.

9. A structure formed of a shape-memory polymer disposed in a flow channel through which biomolecules flow,
wherein the structure is configured to have a deformation amount adjusted by controlling a heating condition.

10. The structure according to claim 9,
wherein predetermined biomolecules are blocked in accordance with the adjustment of the deformation amount.

11. A fluidic device provided with a valve formed of a shape-memory polymer disposed in a flow channel,
wherein the valve is at least one selected from the group consisting of a normally open valve of which the state is deformed from an open state in which fluid flows through the flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.

12. A fluidic device provided with a valve formed of a shape-memory polymer disposed in a flow channel, the fluidic device comprising:
a normally open valve which is disposed on a first surface and of which the state is deformed from an open state in which fluid flows through the flow channel to a closed state in which the flow of the fluid is blocked; and
a normally closed valve which is disposed on a second surface facing the first surface and of which the state is deformed from the closed state in which the flow of the fluid in the flow channel is blocked to the open state in which the fluid flows through the flow channel,
wherein the normally open valve and the normally closed valve are disposed so as to face each other.

13. A fluidic device provided with a pump configured to have a plurality of valves formed of a shape-memory polymer disposed in flow channels,
wherein the plurality of valves are at least two selected from the group consisting of a normally open valve of which the state is deformed from an open state in which fluid flows through the flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.

14. The fluidic device according to any one of claims 11 to 13, further comprising:
a controlling unit for controlling the open state and the closed state by changing the temperature of at least a portion of the shape-memory polymer.

15. The fluidic device according to any one of claims 11 to 14, further comprising:
a heating unit for controlling the deformation amount of the shape-memory polymer by controlling a heating condition to control the flow rate of the fluid in the flow channel.

16. The fluidic device according to claim 15,
wherein the heating unit comprises an electrode.

17. The fluidic device according to claim 15,
wherein the heating unit comprises a light absorbing agent.

18. A valve sheet on which a valve formed of a shape-memory polymer is disposed,
wherein the valve is at least one selected from the group consisting of a normally open valve of which the state is deformed from an open state in which fluid flows through a flow channel to a closed state in which the flow of the fluid is blocked; a normally closed valve of which the state is deformed from the closed state in which the flow of the fluid in the flow channel is blocked to the open state in which the fluid flows through the flow channel; and a series valve which is formed by disposing the normally closed valve and the normally open valve in series.

19. A method of manufacturing a valve sheet, comprising:
molding a normally closed valve on the sheet by forming a first recess portion on a sheet made of a shape-memory polymer through molding processing or machining at a temperature less than the melting point of the shape-memory polymer and making the first recess portion flat by applying an external force to the first recess portion at a temperature within a range of higher than or equal to a shape recovery temperature of the shape-memory polymer and less than the melting point of the shape-memory polymer; and/or
molding a normally open valve on the sheet by providing a second recess portion by applying an external force on the sheet at a temperature within the range of higher than or equal to the shape recovery temperature of the shape-memory polymer and less than the melting point of the shape-memory polymer.

20. A method of manufacturing a valve sheet, comprising:
molding a normally closed valve on the sheet by forming a first penetration hole on a sheet formed of a shape-memory polymer through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point of the shape memory polymer; and/or
molding a normally open valve on the sheet by providing a second penetration hole by applying an external force on the sheet at a temperature within the range of higher than or equal to the shape recovery temperature of the shape-memory polymer and less than the melting point of the shape-memory polymer.

21. A method of manufacturing a fluidic device formed of a valve sheet and a flow channel forming layer, the method comprising:
(a) manufacturing the valve sheet through a method of manufacturing the valve sheet including at least a step selected from the group consisting of a step of forming a first recess portion on a sheet formed of a shape-memory polymer through molding processing or machining at a temperature less than the melting point of the shape-memory polymer, making the first recess portion flat by applying an external force to the first recess portion at a temperature within a range of higher than or equal to a shape recovery temperature of the shape-memory polymer and less than the melting point of the shape-memory polymer, and molding a first normally closed valve on the sheet,
a step of providing a second recess portion by applying an external force on the sheet at a temperature within the range of higher than or equal to the shape recovery temperature of the shape-memory polymer and less than the melting point of the shape-memory polymer and molding a first normally open valve on the sheet,
a step of forming a first penetration hole through molding processing or machining at a temperature less than the melting point of the shape-memory polymer, making the first penetration hole flat by applying an external force to the first penetration hole at a temperature within a range of higher than or equal to a shape recovery temperature of the shape-memory polymer and less than the melting point of the shape-memory polymer, and molding a second normally closed valve on the sheet, and
a step of providing a second penetration hole by applying an external force on the sheet at a temperature within the range of higher than or equal to the shape recovery temperature of the shape-memory polymer and less than the melting point of the shape-memory polymer and molding a second normally open valve on the sheet; and
(b) laminating the valve sheet, which is manufactured in the step (a), and the flow channel forming layer.
